# EUROPÄISCHE PATENTANMELDUNG

(11) **EP 3 961 181 A1**
(43) Veröffentlichungstag der Anmeldung: **02.03.2022**
(21) Anmeldenummer: 20192556.7
(22) Anmeldetag: 25.08.2020
(51) Int. Cl.: G01M 13/04, G01R 31/34, H02K 11/20

(54) **VERFAHREN ZUR ERFASSUNG UND/ODER AUSWERTUNG EINES LAGERSTROMEREIGNISSES**

(71) Anmelder: Siemens Aktiengesellschaft, 80333 München (DE)
(72) Erfinder: Scheibner, Dirk, 90473 Nürnberg (DE); Tischmacher, Hans, 91207 Lauf (DE); Zettner, Jürgen, 90587 Veitsbronn (DE)

(57) **Zusammenfassung**

Die Erfindung betrifft ein Verfahren zur Erfassung und/oder Auswertung eines Lagerstromereignisses in einem Lager (1) einer dynamoelektrischen rotatorischen Maschine (3), wobei eine Zuordnung, insbesondere graphische Zuordnung, einer Pulsdauer (t_{P}) und/oder einer Pulshöhe (U_{P}) und/oder eines Pulsintegrals (A) zur Wellenlage erfolgt. Die Erfindung betrifft zudem eine Welle (4), eine dynamoelektrische rotatorische Maschine (3) sowie ein Antriebssystem (23).

## Beschreibung

Die Erfindung betrifft ein Verfahren zur Erfassung und/oder Auswertung eines Lagerstromereignisses in einem Lager einer dynamoelektrischen rotatorischen Maschine.

In dynamoelektrischen rotatorischen Maschinen können elektrische Ströme (Lagerströme, engl.: bearing currents) in Lagern auftreten, welche die Lebensdauer dieser Lager erheblich reduzieren. Lagerströme sind elektrische Ströme, die in Wälz- und/oder Gleitlagern dynamoelektrischer rotatorischer Maschinen auftreten. Sie werden meist durch elektrische Spannungen (sogenannte Lagerspannungen) hervorgerufen, die oft aufgrund elektrischer und/oder magnetischer Streufelder innerhalb der Maschine und/oder durch Fremdströme, die von außen kommend über die Maschine fließen, entstehen.

Sobald die Lagerspannung über einer Durchbruchspannung (auch Frittspannung genannt) des Schmierfilms liegt, findet ein Stromfluss statt.

Negative Wirkungen von Lagerströmen sind beispielsweise eine Fettverbrennung, was zu einer Reduzierung einer Restschmierfähigkeit führt, eine Kraterbildung in einer Laufbahn und in Wälzkörpern sowie eine Riffelbildung in den Laufbahnen.

Lagerströme führen zu erheblichem Wartungsaufwand bei Anwendern sowie zu hohen Gewährleistungskosten bei Herstellern. Nach dem derzeitigen Stand der Technik werden durch elektrische Lagerströme geschädigte Lager erst bei Auffälligkeit, z.B. durch Geräuschentwicklung oder verbranntes Lagerfett, bemerkt und ausgetauscht. Dies führt oft zu Anlagenstillständen, die enorme Kosten verursachen.

Der Erfindung liegt daher die Aufgabe zugrunde, eine dynamoelektrische rotatorische Maschine dahingehend zu verbessern.

Die Lösung der Aufgabe gelingt durch Anspruch 1, d.h. ein Verfahren zur Erfassung und/oder Auswertung eines Lagerstromereignisses in einem Lager einer dynamoelektrischen rotatorischen Maschine mit folgenden Schritten:
Erfassen einer Messgröße, insbesondere einer Lagerspannung, zu einem Zeitpunkt oder zu einer Mehrzahl an Zeitpunkten; Erfassen einer im Zeitpunkt des Erfassens der Messgröße vorliegenden Wellenlage; Erzeugen einer Hüllkurve um die erste Ableitung eines durch Erfassen der Messgröße ermittelten Messwerts oder mehrerer Messwerte zur Bildung einer Signalkurve; Bestimmen einer Pulsdauer der Messgröße, wobei eine Dauer zwischen einer Überschreitung eines ersten Schwellwerts und einer Unterschreitung eines zweiten Schwellwerts durch die Signalkurve gemessen wird; Bestimmen einer maximalen Pulshöhe der Signalkurve zwischen dem ersten Schwellwert und dem zweiten Schwellwert; Bestimmen eines Pulsintegrals auf Basis einer von Pulsdauer und Signalkurve eingeschlossenen Fläche; Zuordnung, insbesondere graphische Zuordnung, der Pulsdauer und/oder der Pulshöhe und/oder des Pulsintegrals zur Wellenlage.

In einer vorteilhaften Ausführung wird die Wellenlage durch eine Umdrehungszeit bezüglich einer Gesamtumdrehungszeit ermittelt.

Zur Ermittlung der Gesamtumdrehungszeit ist die Welle vorteilhaft markiert.

In einer vorteilhaften Ausführung wird die Zuordnung der Pulsdauer und/oder der Pulshöhe und/oder des Pulsintegrals zur Wellenlage in einem Histogramm aufgetragen.

Das Histogramm ist von Vorteil, da hierbei eine Häufigkeitsverteilung gut darstellbar ist.

In einer vorteilhaften Ausführung wird ein potentieller Schaden des Lagers durch eine Erkennung eines charakteristischen Musters im Histogramm detektiert.

Dies bietet die Möglichkeit, einen voraussichtlichen Zeitpunkt eines Lagerausfalls und damit den optimalen Zeitpunkt eines notwendigen Lageraustausches zu bestimmen.

Eine Auswertung dieser ortsaufgelösten Histogramme lässt verschiedene Rückschlüsse zu. Existieren Lagerstromereignisse über einzelne Wälzkörper oder Gruppen von Wälzkörpern, so ermöglicht eine Zählung einer Anzahl von Häufungen die Zuordnung der vermutlich betroffenen Fläche, über welche die Energie abgeleitet wird und ermöglicht damit ein Maß für die Schwere der Schädigung. Zudem beeinflussen Lastkomponenten in radialer Richtung in Antriebssträngen die Schmierspaltdicke in einer entsprechenden Winkellage, wodurch die Bedingung für Lichtbogenentladungen ebenfalls entsprechend bevorzugt auftreten.

Eine Riffelbildung entsteht meist im entsprechenden Winkellagebereich und durch die Auftragung bezüglich der Wellenlage ist eine Auswertung der Impulsleistungen signifikant, da eine hohe Anzahl wiederholt lokal auftretender Lagerstromereignisse schädlicher ist, als eine im Umfang gleich verteilte Anzahl.

In einer vorteilhaften Ausführung wird eine Dichte von Lagerstromereignissen und/oder eine durch Lagerstromereignisse eingenommene Fläche bezüglich der Wellenlage ermittelt.

Eine Fokussierung auf einzelne Lagerbereiche ist hierbei von Vorteil, da dadurch Schäden besser erkannt werden können.

Die Dichte ist ein Maß für eine Häufigkeit der auftretenden Lagerstromereignisse.

In einer vorteilhaften Ausführung wird auf Basis der Fläche eine Berechnung einer über einen Lagerschmierspalt übertragenen Energie ermittelt.

In einer vorteilhaften Ausführung wird ein Bereich mit der erhöhten Dichte identifiziert.

Schäden können somit gut erkannt werden.

Ein Auftragen der Lagerstromereignisse zur Winkellage (bei Kenntnis der Winkelgeschwindigkeit und/oder Winkellage) ermöglicht eine Zuordnung von Lagerstromereignissen auch bei Beschleunigungsvorgängen und ermöglicht damit auch eine Überwachung dynamischer Antriebe mit diesem Verfahren. Denkbar ist somit bei Fahrbetrieb oder zyklischen Vorgängen (wie z.B. bei Servopressen) eine Auswertung der Lagerstromereignisse über einer Anzahl der Beschleunigungsvorgänge.

Der Bezug kann alternativ zu einer Wellendrehzahl auch zu abgeleiteten Größen wie typischen Lagerfrequenzen erfolgen, z.B. Innenringüberrollfrequenz, Außenringüberrollfrequenz, Kugelumlauffrequenz und Käfigfrequenz.

Eine Umrechnung kann bei Kenntnis der Lagergeometrie über die Wellendrehzahl erfolgen. Alternativ kann die Zuordnung zu weiteren im Antriebsstrang vorkommenden, mit der Rotationsfrequenz der überwachten Maschine einhergehenden Frequenzen (wie z.B. Lastmodulationen, periodische Getriebeeinflüsse) oder deren harmonische Frequenzen höherer Ordnung, durchgeführt werden.

In einer vorteilhaften Ausführung wird der Bereich mit einer gegenüber einem anderen Bereich erhöhten Dichte identifiziert.

In einer vorteilhaften Ausführung wird der Bereich mit einer gegenüber einer in einer früheren Erfassung ermittelten Dichte des gleichen Bereichs erhöhten Dichte identifiziert.

Auf diese Weise kann eine im Anlagenbetrieb aufgetretene Schädigung erkannt werden.

Durch eine Verwendung zusätzlicher äußerer Messwerte (z.B. Erdströme, Klemmenspannung, Wellenstrom, Wellenspannung, Lagertemperatur, Schwingung, Drehzahl, indirekte Lagerströme über Isolationsüberbrückung, Spannungssteilheit, Pulsfrequenz, usw.) lassen sich auf der Basis eines Simulationsmodells innere Messwerte (Größe des Lagerschmierspalts, Lagerkapazität, Lagerströme, usw.) berechnen. Weiterhin ist es möglich durch eine Kombination von inneren und äußeren Werten sogenannte Prozesskennwerte zu bilden, wie z.B. Häufigkeiten von Lagerstromspitzen, Häufigkeiten von Spannungsspitzen, Häufigkeiten von Spannungssteilheiten, Verhältnisbildung von einer aktuellen Häufigkeit zu der bei Anlageninbetriebnahme, Aufteilung in Häufigkeitsklassen und Berechnung der Steigerung über einen Zeitraum Δt, Berechnung der über den Lagerschmierspalt übertragenen Energie aus Produkt von gemessener Lagerspannung und errechnetem Lagerstrom durch Integration über die Zeit.

Damit wird eine Abschätzung der Lagerlebensdauer ermöglicht. Ebenso ist eine Abschätzung der über einen Lagerschmierspalt übertragenen Energie bzw. Leistungsdichte möglich.

Die Lösung der oben gestellten Aufgabe gelingt ferner durch Anspruch 10, d.h. eine Welle für eine dynamoelektrische rotatorische Maschine, dergestalt, dass ein derartiges Verfahren ausführbar ist.

Die Welle weist vorteilhaft eine Vorrichtung auf, die dergestalt ist, dass das Verfahren ausführbar ist.

Die Lösung der Aufgabe gelingt zudem durch Anspruch 11, d.h. eine dynamoelektrische rotatorische Maschine, insbesondere zur Durchführung eines derartigen Verfahrens, aufweisend: einen Stator; einen drehbar gelagerten Rotor; eine Welle; eine Vorrichtung zur Erfassung einer Messgröße, insbesondere einer Lagerspannung und/oder zur Erfassung einer Wellenlage.

In einer vorteilhaften Ausführung weist die Vorrichtung einen ersten Sensor zur Erfassung einer Messgröße, insbesondere einer Lagerspannung, und einen zweiten Sensor zur Erfassung einer Wellenlage oder einen kombinierten Sensor zur Erfassung der Messgröße, insbesondere der Lagerspannung, und zur Erfassung der Wellenlage auf.

Dies wird in den Figuren näher beschrieben.

In einer vorteilhaften Ausführung ist die dynamoelektrische rotatorische Maschine verbindbar mit wenigstens einer Auswerteeinheit.

Die Lösung der Aufgabe gelingt ferner durch Anspruch 14, d.h. ein Antriebssystem, aufweisend einen Umrichter und eine dynamoelektrische rotatorische Maschine.

Die Erfindung bietet den Vorteil, dass Lagerströme bzw. Lagerstromereignisse an elektrischen Maschinen, insbesondere bei Betrieb mit Leistungselektronik, erkannt werden und so eine Vorhersage einer Lebensdauer der Motorlager getroffen werden kann. Durch Lagerströme geschädigte Lager können somit nicht erst bei Auffälligkeit, z.B. durch Geräuschentwicklung oder verbranntes Lagerfett, bemerkt und ausgetauscht werden, sondern bereits viel früher. Auf diese Weise können Anlagenstillstände, die enorme Kosten verursachen, vermieden werden.

Im Folgenden wird die Erfindung anhand der in den Figuren gezeigten Ausführungsbeispielen näher beschrieben und erläutert. Es zeigen:
- FIG 1: das erfindungsgemäße Verfahren,
- FIG 2: beispielhaft eine schematische Darstellung einer Lagerstromdetektion mit Erfassung der Wellenlage,
- FIG 3, FIG 4 und FIG 5: eine beispielhafte Zuordnung von Lagerstromereignissen zur Wellenlage,
- FIG 6, FIG 7 und FIG 8: eine weitere beispielhafte Zuordnung von Lagerstromereignissen zur Wellenlage,
- FIG 9 und FIG 10: die Folgen einer statischen Radiallast,
- FIG 11 und FIG 12: die Folgen einer periodisch mit einer Innenring-Drehfrequenz einhergehenden Radiallast,
- FIG 13: ein Radiallager,
- FIG 14: einen Drehzahlverlauf eines Wälzkörpers, insbesondere der Kugel, in einem Radiallager.

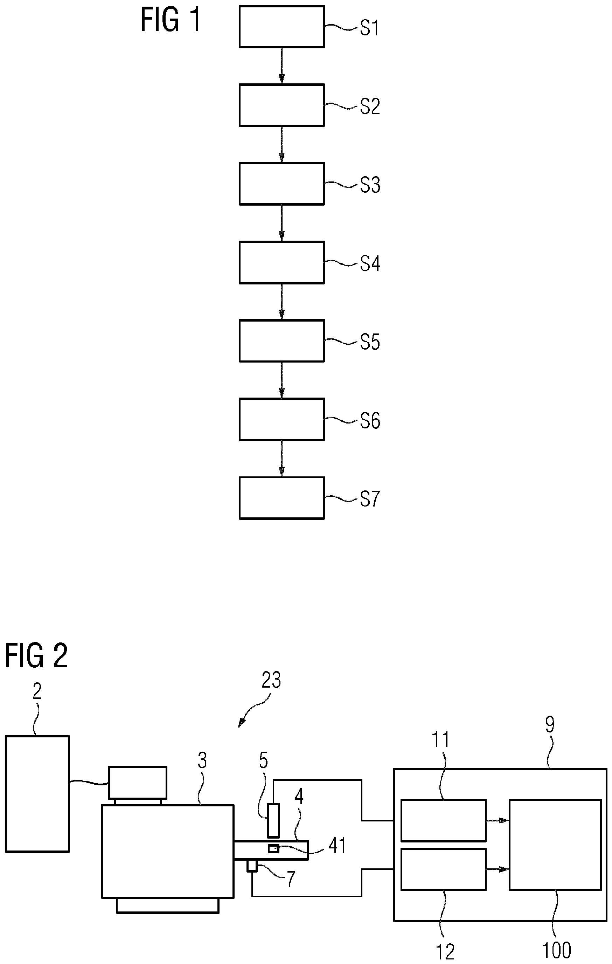

FIG 1 zeigt das erfindungsgemäße Verfahren.

In einem Verfahrensschritt S1 erfolgt ein Erfassen einer Messgröße, insbesondere einer Lagerspannung, zu einem Zeitpunkt oder zu einer Mehrzahl an Zeitpunkten.

In einem Verfahrensschritt S2 erfolgt ein Erfassen einer im Zeitpunkt des Erfassens der Messgröße vorliegenden Wellenlage.

In einem Verfahrensschritt S3 erfolgt ein Erzeugen einer Hüllkurve um die erste Ableitung eines durch Erfassen der Messgröße ermittelten Messwerts oder mehrerer Messwerte zur Bildung einer Signalkurve.

In einem Verfahrensschritt S4 erfolgt ein Bestimmen einer Pulsdauer der Messgröße, wobei eine Dauer zwischen einer Überschreitung eines ersten Schwellwerts und einer Unterschreitung eines zweiten Schwellwerts durch die Signalkurve gemessen wird.

In einem Verfahrensschritt S5 erfolgt ein Bestimmen einer maximalen Pulshöhe der Signalkurve zwischen dem ersten Schwellwert und dem zweiten Schwellwert.

In einem Verfahrensschritt S6 erfolgt ein Bestimmen eines Pulsintegrals auf Basis einer von Pulsdauer und Signalkurve eingeschlossenen Fläche.

In einem Verfahrensschritt S7 erfolgt eine Zuordnung, insbesondere graphische Zuordnung, der Pulsdauer und/oder der Pulshöhe und/oder des Pulsintegrals zur Wellenlage.

FIG 2 zeigt beispielhaft eine schematische Darstellung einer Lagerstromdetektion mit Erfassung der Wellenlage.

Die Figur zeigt ein Antriebssystem 23, aufweisend einen Umrichter 2, der mit einer dynamoelektrischen rotatorischen Maschine 3 verbunden ist. Die Maschine 3 umfasst eine Welle 4. Die Figur zeigt einen Sensor 5 zur Erfassung der Wellenlage. Dies ist z.B. ein optischer Sensor, welcher mit einer Marke 41 (bzw. Markierung) auf der Welle 4 interagiert.

Die Figur zeigt ferner einen Sensor 7 zur Erfassung der Messgröße, insbesondere der Lagerspannung. Die Erfassung gelingt z.B. mittels einer Bürste und einer kapazitiven Auskopplung.

Die Funktionen der Sensoren 5 und 7 können auch von einem kombinierten Sensor wahrgenommen werden.

Die Figur zeigt eine Lagerstromsensoreinheit 9, in welcher eine erste Auswerteeinheit 11 die Wellenlage auswertet und eine zweite Auswerteeinheit 12 die Lagerspannung, insbesondere einen Impuls der Lagerspannung, auswertet. In einer dritten Auswerteeinheit 100 findet eine Auswertung einer Korrelation von beispielsweise Impulszeitpunkt und Wellenlage statt. Ferner kann eine Histogrammbildung angestoßen werden.

Insbesondere für gleichlaufende Antriebe kann dies durch ein Auftragen über der Umdrehungszeit erfolgen. Die Lagerstromereignisse, deren Häufigkeit und Schwere bzw. Schädlichkeit werden damit bei Gleichlauf zur Winkellage zuordenbar.

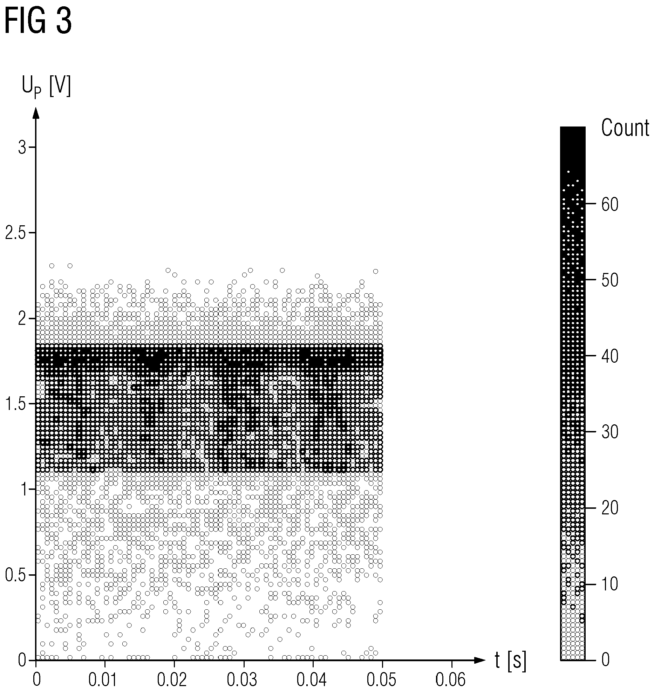

FIG 3, FIG 4 und FIG 5 zeigen eine beispielhafte Zuordnung von Lagerstromereignissen zur Wellenlage. Die Histogramme zeigen eine Häufigkeit der Lagerstromereignisse an. Dies ist durch "Count" dargestellt.

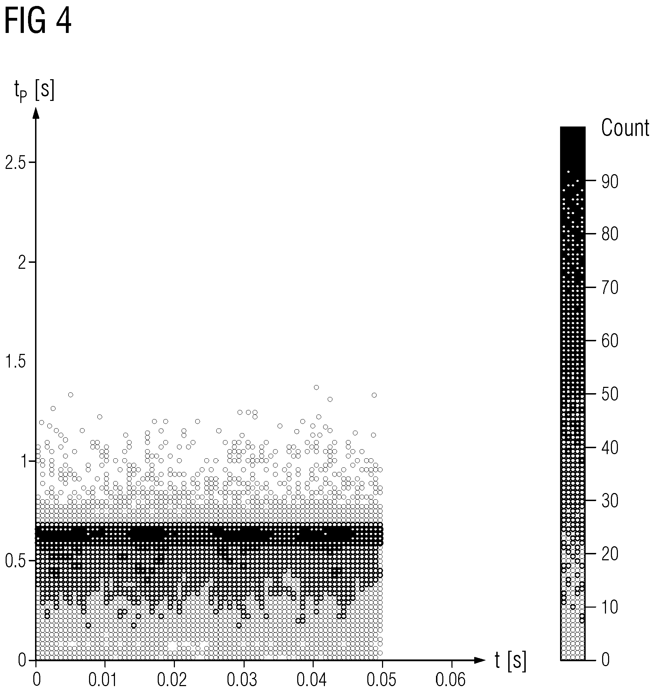

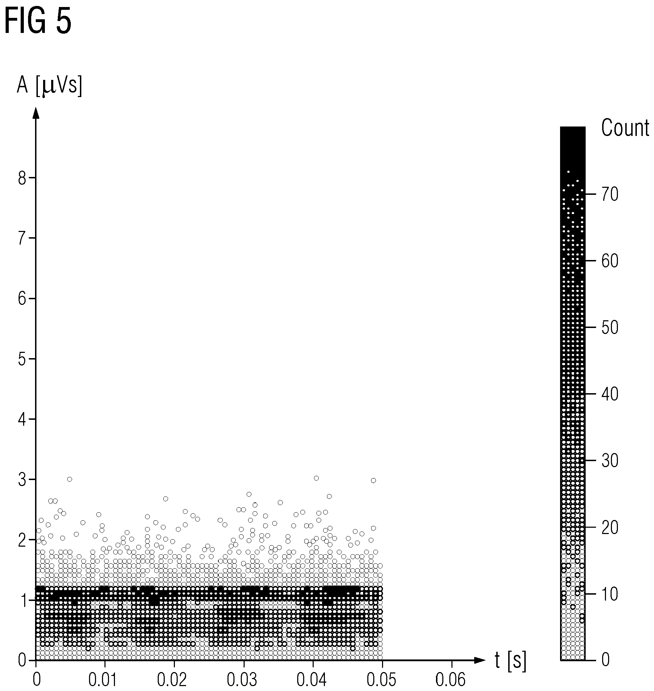

Die Histogramme bilden auf der y-Achse eine Pulshöhe U_{P} [V] (in FIG 3), eine Pulsdauer t_{P} [s] (in FIG 4) und ein Pulsintergral A [pVs] (in FIG 5) ab. Das Pulsintegral lässt Rückschlüsse auf eine Pulsenergie zu. Die x-Achse stellt eine Umdrehungszeit t [s] dar. Die Figur liefert Ergebnisse für 1200 Umdrehungen pro Minute.

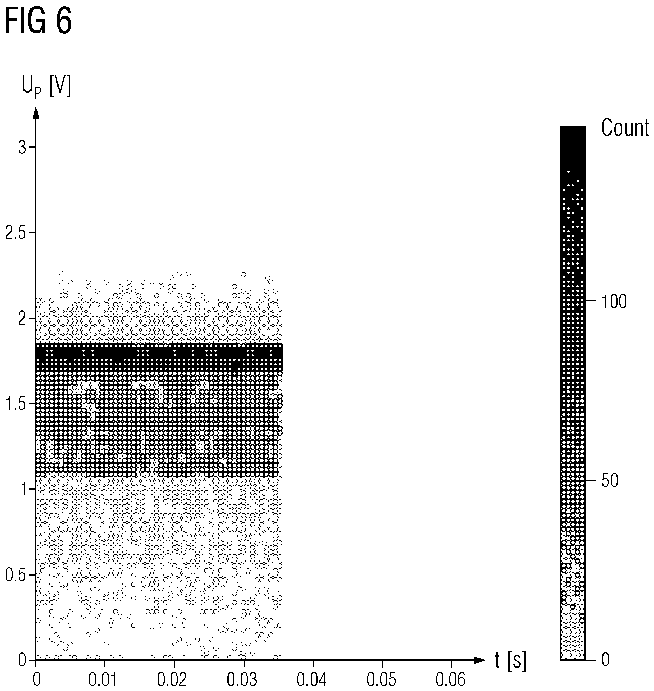

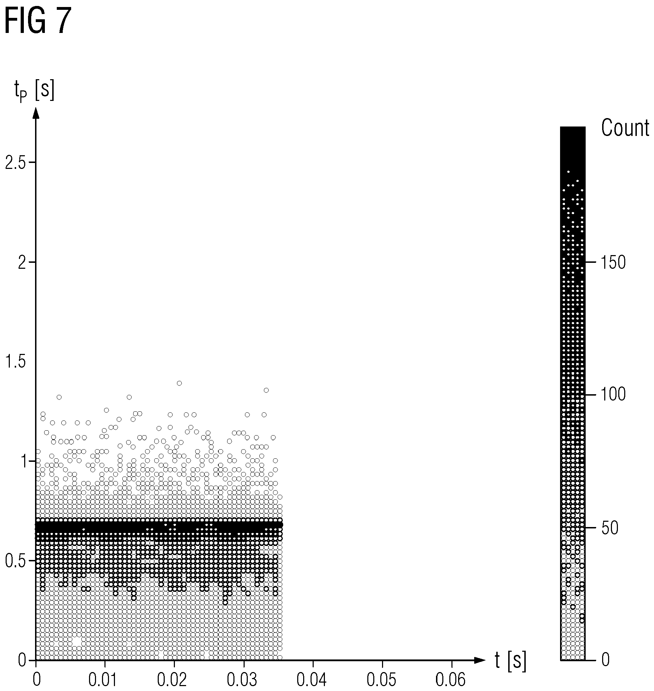

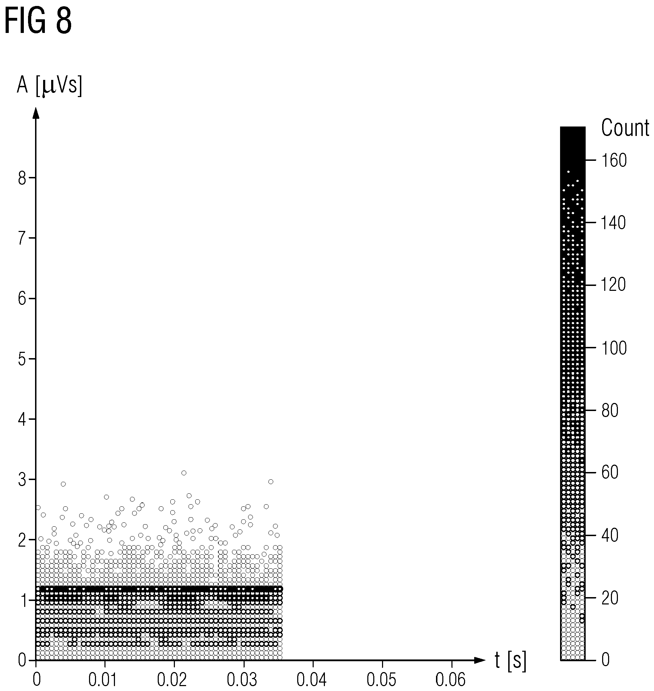

FIG 6, FIG 7 und FIG 8 zeigen eine weitere beispielhafte Zuordnung von Lagerstromereignissen zur Wellenlage. Die Figuren liefert Ergebnisse für 1800 Umdrehungen pro Minute.

Die Histogramme lassen Rückschlüsse auf verschiedene Lagerstromereignisse zu. Periodische Laständerungen können z.B. zu verschmierten oder besonders zentrierten Ereignissen führen. Eine weitere Auftragung der Lagerstrom-Impulsleistungen kann über der Periode der Lastmodulation erfolgen.

Andere Berührwinkel (insbesondere diejenigen, die sich mit der Last verändern) können unterschiedlich ausgeprägte lokale Muster zeigen und somit lokale Schäden aufdecken. Eine zeitliche Veränderung einer Winkelausdehnung im Histogramm ist ein Maß für den Verlauf der Schädigung und das Wachstum der geschädigten Zone. Damit ist die laterale Ausdehnung des Lagerstromschadens abschätzbar.

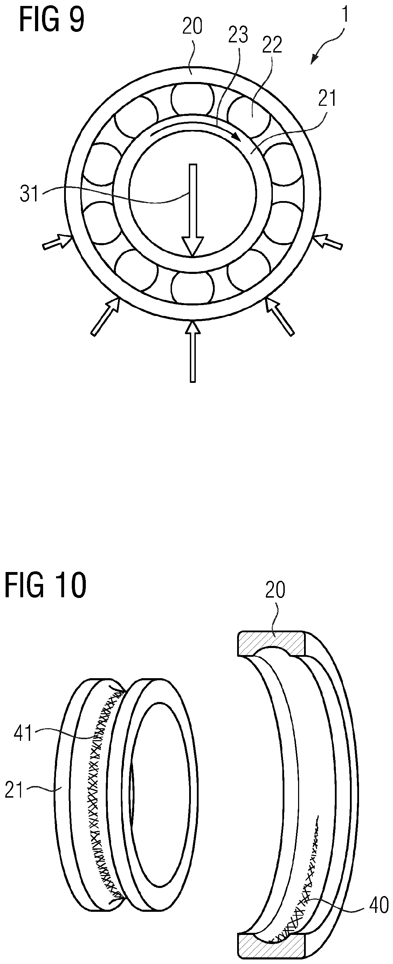

FIG 9 und FIG 10 zeigen die Folgen einer statischen Radiallast 31. Ein Lager 1 umfasst einen Außenring 20 und einen Innenring 21. Zwischen dem Außenring 20 und dem Innenring 21 ist eine Mehrzahl an Kugeln 22 angeordnet. Das in der Figur gezeigte Lager 1 rotiert beispielsweise im Uhrzeigersinn (mit Pfeil 23 dargestellt).

Die Radiallast 31 verursacht die in FIG 10 gezeigten Schädigungen 41 am Innenring 21 und Schädigungen 40 am Außenring 20. Schädigungen sind beispielsweise Krater- und Riffelbildung.

Bei einer statischen Radiallast 31 ist eine über der Winkellage am Umfang der Laufbahn verteilte Schädigung typischerweise ungleichförmig, da die Radiallast 31 in einer bevorzugten Winkellage durch minimal veränderte Schmierspalte, bevorzugte radial-lokale Lagerstromereignisse generiert.

Ist die Radiallast statisch, so wird der Schmierspalt in dieser Richtung verdrückt. Somit sind an einer Stelle bzw. in einem Bereich die Lagerstrombedingungen erfüllt und Lagerstromereignisse treten bevorzugt dort auf. Dies passiert statisch, d. h. einer feststehender Außenring 20 des Lagers wird lokal in diesem Bereich geschädigt. Die Stelle kann, aber muss nicht mit der Stelle des kleinsten Schmierspaltes übereinstimmen, also nicht unbedingt in direkter Richtung der Radiallast.

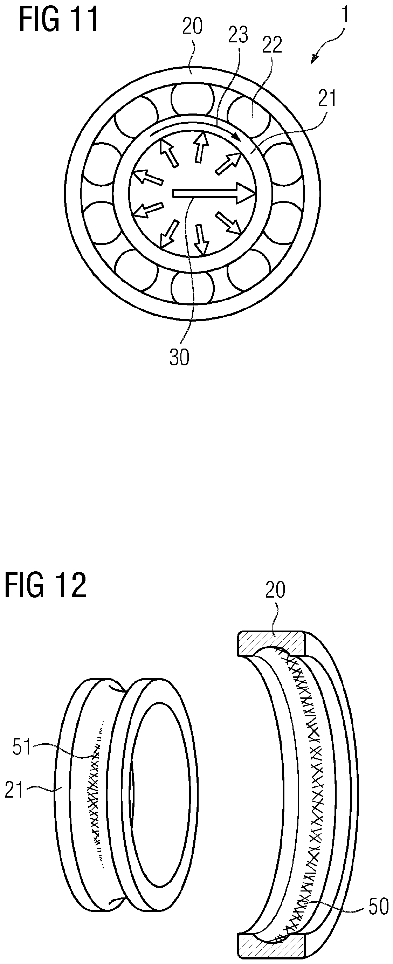

FIG 11 und FIG 12 zeigen die Folgen einer periodisch mit einer Innenring-Drehfrequenz einhergehenden Radiallast 30.

Die in FIG 12 gezeigten Schädigungen 51 am Innenring 21 und Schädigungen 50 am Außenring 40 können dadurch verursacht werden.

Eine Radiallast, die mit einer Drehfrequenz der Welle variiert tritt häufig auf, da z.B. Unwuchten angetriebener Aggregate und Rollen o.Ä. zu periodischen Modulationen führen können. Sodann tritt der Schmierspalt, der die besten Bedingungen für Lagerströme erfüllt, mit dieser Frequenz auf und ist diesbezüglich in einer festen Winkellage zu erwarten.

Eine Schwere der Lagerstromereignisse ist abhängig von diversen Faktoren, wie z.B. einem Wellenpotential, einem Schmierspalt, einer Viskosität eines Lagerfetts, einer Temperatur sowie einer dynamischen und/oder radialen Last.

Eine daraus resultierende Schädigung der Laufbahn des Lagers 1 hängt zumeist von einer lokalen Energiedichte und der Enthalpie, die zur Umformung des Laufbahn-/Wälzkörpermaterials notwendig ist, ab. Ein Schadensfortschritt wird zudem von lokalen mechanischen Spannungen beeinflusst, die in lagerstromgeschädigten Bereichen dann höher sind, wenn die Riffelbildung mit hoher Rautiefe einhergeht.

Ein Schaden äußert sich meist durch Maschinenschwingungen. Eine Schadensauswirkung ist abhängig von einer geometrischen Ausdehnung des Schadens, insbesondere Riffeltiefe, Ortsfrequenz und Riffelverteilung (lokal oder auf gesamter Laufbahn) .

Der Schmierspalt ist in der Regel nicht exakt gleich am Umfang verteilt, insbesondere durch Fertigungstoleranzen, Verzug durch Einbaufehler, Abnutzung und beginnende Lagerschäden sowie Fehler auf einem Wälzkörper (in Form der Kugel 22), wodurch sich für Lagerstromereignisse besonders bevorzugte Stellen ergeben können.

Eine bessere Bewertung der Lagerstromereignisse bezüglich ihrer schädigenden Wirkung erreicht man durch die im Verfahren beschriebene ortsauflösende Erfassung der Lagerstromereignisse.

Dazu wird das Auftreten von Lagerstromereignissen kontinuierlich durch Erfassen einer charakteristischen Messgröße, insbesondere der Lagerspannung bzw. der Ableitung der Lagerspannung, detektiert. Die impulsartigen Signalverläufe des Lagerstromereignisses werden nachfolgend ausgewertet, z.B. mittels Hüllkurvenbildung und Ermittlung charakteristischer Größen des Ereignisses, z.B. Pulshöhe, Pulsdauer, Pulsintegral und Zeitpunkt des Auftretens.

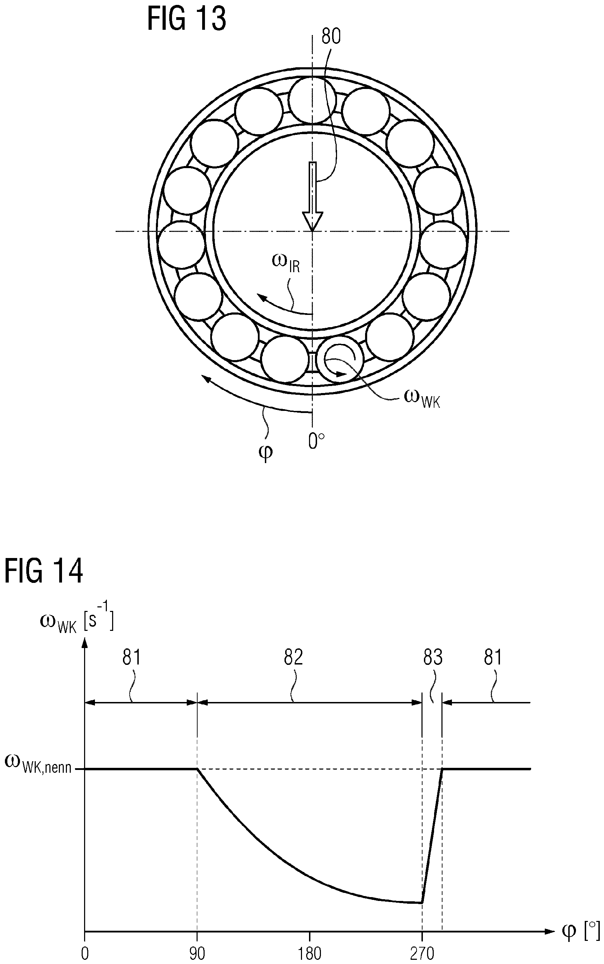

FIG 13 zeigt ein Radiallager, aufweisend den Innenring 21, den Außenring 20 und eine Mehrzahl an Kugeln 22. Das Lager rotiert mit einer Kreisfrequenz ω_{IR}.

Eine Kugel rotiert mit einer Kreisfrequenz ω_{WK}.

FIG 14 zeigt einen Drehzahlverlauf eines Wälzkörpers, insbesondere der Kugel 22, in einem Radiallager.

Bei bestimmten Fehlern treten charakteristische Verteilungen auf, die auf Basis eines Histogramms klassifizierbar sind. Im normalen Betrieb werden die Kugeln 22 bei Eintritt in eine Lastzone 81, in der Figur von einem Winkel ϕ = 0° bis zu ϕ = 90°, beschleunigt und rollen in der Lastzone 81 ab.

Lagerstromereignisse treten dann verstärkt beim Eintritt in die Lastzone 81 auf. Dies führt zu im Wesentlichen scharf abgegrenzten Bereichen im Histogramm.

Eine Unterlast des Lagers aufgrund fehlender Vorspannung stellt hingegen einen Fehlerfall dar. In diesem Fall drehen die Kugeln 22 nicht, sondern schlupfen. Dies führt zu verschmierten Impulsen der Lagerstromereignisse über der Wellenlage, da ein definierter Eintritt in die Lastzone 81 fehlt.

Dies ist in einer Verzögerungszone 82 und einer Beschleunigungszone 83 dargestellt. Die tatsächliche Kreisfrequenz ω_{WK} weicht von einer Nennkreisfreuenz ω_{WK,nenn}, die eine gleichförmige Rotation beschreibt, ab. Das Schlupfen äußert sich z.B. dadurch, dass von ϕ = 90° bis zu ϕ = 270° die Kreisfrequenz ω_{WK} reduziert ist und dann steil ansteigt.

Eine Auswertung der ortsaufgelösten Lagerstromereignisse erlaubt eine Abgrenzung von echten Lagerstromereignissen gegenüber Störungen (z.B. Schaltflanken des Umrichters, externe Störungen, Teilentladungen). Durch eine Identifikation von gestörten Bereichen ist eine bessere Parametrierung einer Lagerstromüberwachung möglich. Dies gelingt z.B. durch ein Ausmitteln aller nicht mit der betrachteten Frequenz korrelierten Werte der Lagerstromereignisse, Festlegen von Amplituden-Schwellen bzw. Ausblenden gestörter Amplitudenbereiche, Ausblenden von Bereichen bestimmter Pulslänge, die von Störungen überlagert sind und Ausblenden von gestörten Frequenzbereichen.

## Patentansprüche

1. Verfahren zur Erfassung und/oder Auswertung eines Lagerstromereignisses in einem Lager (1) einer dynamoelektrischen rotatorischen Maschine (3) mit folgenden Schritten:
- Erfassen einer Messgröße, insbesondere einer Lagerspannung, zu einem Zeitpunkt oder zu einer Mehrzahl an Zeitpunkten,
- Erfassen einer im Zeitpunkt des Erfassens der Messgröße vorliegenden Wellenlage,
- Erzeugen einer Hüllkurve um die erste Ableitung eines durch Erfassen der Messgröße ermittelten Messwerts oder mehrerer Messwerte zur Bildung einer Signalkurve,
- Bestimmen einer Pulsdauer (t_{P}) der Messgröße, wobei eine Dauer zwischen einer Überschreitung eines ersten Schwellwerts und einer Unterschreitung eines zweiten Schwellwerts durch die Signalkurve gemessen wird
- Bestimmen einer maximalen Pulshöhe (U_{P}) der Signalkurve zwischen dem ersten Schwellwert und dem zweiten Schwellwert,
- Bestimmen eines Pulsintegrals (A) auf Basis einer von Pulsdauer (t_{P}) und Signalkurve eingeschlossenen Fläche,
- Zuordnung, insbesondere graphische Zuordnung, der Pulsdauer (t_{P}) und/oder der Pulshöhe (U_{P}) und/oder des Pulsintegrals (A) zur Wellenlage.

2. Verfahren nach Anspruch 1, wobei die Wellenlage durch eine Umdrehungszeit bezüglich einer Gesamtumdrehungszeit ermittelt wird.

3. Verfahren nach einem der vorhergehenden Ansprüche, wobei die Zuordnung der Pulsdauer (t_{P}) und/oder der Pulshöhe (U_{P}) und/oder des Pulsintegrals (A) zur Wellenlage in einem Histogramm aufgetragen wird.

4. Verfahren nach Anspruch 3, wobei ein potentieller Schaden des Lagers (1) durch eine Erkennung eines charakteristischen Musters im Histogramm detektiert wird.

5. Verfahren nach einem der vorhergehenden Ansprüche, wobei eine Dichte von Lagerstromereignissen und/oder eine durch Lagerstromereignisse eingenommene Fläche bezüglich der Wellenlage ermittelt wird.

6. Verfahren nach einem der vorhergehenden Ansprüche, wobei auf Basis der Fläche eine Berechnung einer über einen Lagerschmierspalt übertragenen Energie ermittelt wird.

7. Verfahren nach einem der vorhergehenden Ansprüche, wobei ein Bereich mit der erhöhten Dichte identifiziert wird.

8. Verfahren nach einem der vorhergehenden Ansprüche, wobei der Bereich mit einer gegenüber einem anderen Bereich erhöhten Dichte identifiziert wird.

9. Verfahren nach einem der vorhergehenden Ansprüche, wobei der Bereich mit einer gegenüber einer in einer früheren Erfassung ermittelten Dichte des gleichen Bereichs erhöhten Dichte identifiziert wird

10. Welle (4) für eine dynamoelektrische rotatorische Maschine (3), dergestalt, dass ein Verfahren nach einem der Ansprüche 1 bis 9 ausführbar ist.

11. Dynamoelektrische rotatorische Maschine (3), insbesondere zur Durchführung eines Verfahrens nach einem der Ansprüche 1 bis 9, aufweisend:
- einen Stator,
- einen drehbar gelagerten Rotor,
- eine Welle (4), insbesondere nach Anspruch 10,
- eine Vorrichtung zur Erfassung einer Messgröße, insbesondere einer Lagerspannung und/oder zur Erfassung einer Wellenlage.

12. Dynamoelektrische rotatorische Maschine (3) nach Anspruch 11, wobei die Vorrichtung aufweist:
- einen ersten Sensor (7) zur Erfassung einer Messgröße, insbesondere einer Lagerspannung, und einen zweiten Sensor (5) zur Erfassung einer Wellenlage
oder
- einen kombinierten Sensor zur Erfassung der Messgröße, insbesondere der Lagerspannung, und zur Erfassung der Wellenlage.

13. Dynamoelektrische rotatorische Maschine (3) nach einem der Ansprüche 11 oder 12, verbindbar mit wenigstens einer Auswerteeinheit (11, 12).

14. Antriebssystem (23), aufweisend einen Umrichter (2) und eine dynamoelektrische rotatorische Maschine (3) nach einem der Ansprüche 11 bis 13.
